# EUROPÄISCHE PATENTSCHRIFT

(11) **EP 2 378 293 B1**
(45) Veröffentlichungstag und Bekanntmachung des Hinweises auf die Patenterteilung: **19.12.2012**
(21) Anmeldenummer: 10003526.0
(22) Anmeldetag: 31.03.2010
(51) Int. Cl.: G01R 1/20, H01C 3/02

(54) **Messanordnung zur Messung eines in einer Stromschiene fliessenden Stroms**
Measuring assembly for measuring a current flowing in a power rail
Dispositif de mesure destiné à mesurer un courant circulant dans un rail conducteur

(43) Veröffentlichungstag der Anmeldung: 19.10.2011
(73) Patentinhaber: Schniewindt GmbH & Co. KG, 58809 Neuenrade (DE)
(72) Erfinder: Graeve, Peter, 58809 Neuenrade (DE)
(74) Vertreter: Lelgemann, Karl-Heinz

(56) Entgegenhaltungen:
- DE-B- 1 018 151
- US-A- 2 223 585
- US-A- 5 596 309

## Beschreibung

Die Erfindung bezieht sich auf eine Messanordnung zur Messung eines in einer Stromschiene fließenden Stroms, mit einem Stromsensor, der als ohmscher Stromsensor ausgebildet, in die Stromschiene eingebaut und vom die Stromschiene durchfließenden Strom durchflossen ist.

Wenn bei bekannten derartigen Messanordnungen Wechselströme bzw. Wechselspannungen bei hohen Frequenzen und mit hoher Genauigkeit erfasst werden sollen, ist es erforderlich, dass derartige Messanordnungen einen auf einer transformatorischen Basis arbeitenden Messsensor, beispielsweise einen Stromwandler od.dgl., aufweisen.

Die US 5 596 309 A (NABESHIMA TAKASHIGE) 21.01.1997 offenbart eine Messanordnung zur Messung eines in einer Stromschiene fließenden Stroms.

Ausgehend von dem vorstehend geschilderten Stand der Technik liegt der Erfindung die Aufgabe zugrunde, die eingangs geschilderte Messanordnung zur Messung eines in einer Stromschiene fließenden Stroms derart weiterzubilden, dass mittels ihr sowohl Gleichströme als auch Wechselströme mit Frequenzen bis in den Kilohertzbereich mit einem geringeren technischkonstruktiven Aufwand und mit hoher Genauigkeit gemessen werden können.

Diese Aufgabe wird erfindungsgemäß dadurch gelöst, dass der in die den zu messenden Strom führende Stromschiene eingebaute ohmsche Stromsensor als widerstandsgewebe mit einer Vielzahl voneinander getrennter und isolierter Leiterdrähte ausgebildet ist. Mit einem derartig ausgestalteten ohmschen Stromsensor ist ein Messbereich realisierbar, der Gleichstrom und Wechselstrom mit einer Frequenz bis zu einigen tausend Hertz abdeckt. Die derart gestaltete erfindungsgemäße Messanordnung kann für Nieder-, Hoch- und Höchstspannungsanwendungen zum Einsatz kommen. Für die Wechselspannungsmessung bei hohen Frequenzen sind im Falle der erfindungsgemäßen Messanordnung keine auf transformatorischer Basis arbeitende Sensoren erforderlich.

Bei einer Ausgestaltung des ohmschen Stromsensors als niederohmiger Widerstand ist es in einfacher Weise möglich, die an diesen niederohmigen Widerstand abfallende Spannung abzugreifen und als primäres Messsignal der Messanordnung zu nutzen.

Gemäß einer vorteilhaften Weiterbildung der erfindungsgemäßen Messanordnung sind die Leiterdrähte, die Bestandteile des Widerstandsgewebes des ohmschen Stromsensors bilden, mäandernd an einem Trägerkörper angebracht.

Der Trägerkörper kann vorteilhaft zylindrisch ausgestaltet sein, wobei die Leiterdrähte dann auf der Mantelfläche des zylindrischen Trägerkörpers angebracht werden können.

Zur Trennung der Leiterdrähte voneinander und zur Fixierung der Leiterdrähte am Trägerkörper kann vorteilhaft ein isolierender Werkstoff eingesetzt werden, wobei als solcher isolierender Werkstoff insbesondere ein für die genannten Zwecke geeignetes Harz verwendet werden kann.

Zur Weiterverarbeitung des Messsignals hat die erfindungsgemäße Messanordnung vorteilhaft eine Elektronikeinheit, der die am ohmschen Stromsensor abfallende und dort mittels eines Spannungsabgriffs abgegriffene Spannung zuführbar ist.

In der Elektronikeinheit kann das an sie weitergeleitete Messsignal vorteilhaft in ein optisches Signal umgewandelt werden, wobei die Elektronikeinheit zweckmäßigerweise einen optischen Sender aufweist, mittels dem das optische Signal über ein optisches Übertragungssystem an eine Messwarte weiterleitbar ist.

Mittels des zweckmäßigerweise aus Lichtwellenleitern aufgebauten optischen Übertragungssystems kann ein dem Messsignal entsprechendes optisches Signal in besonders hoher Qualität an die Messwarte weitergeleitet werden.

Vorteilhaft ist das optische Signal in der Messwarte wieder zurück in ein elektrisches Signal verwandelbar und als elektrisches Signal einer Messwertverarbeitungseinheit bzw. einem Leitsystem zuführbar.

Die erfindungsgemäße Messanordnung kann technisch-konstruktiv mit einem geringen Aufwand und mit hoher Betriebssicherheit ausgestaltet werden, wenn die Elektronikeinheit und der optische Sender einerseits galvanisch getrennt von der Stromschiene und dem ohmschen Stromsensor andererseits in einem gemeinsamen Gehäuse angeordnet sind.

Für einen zuverlässigen Betrieb der erfindungsgemäßen Messanordnung kann das Gehäuse vorteilhaft an seinen beiden Stirnseiten, durch die hindurch die Stromschiene eingeführt ist, jeweils eine Abschirmelektrode aufweisen.

Der Einbau des ohmschen Stromsensors in die Stromschiene wird zweckmäßigerweise mittels zweier geeigneter Anschlussteile realisiert.

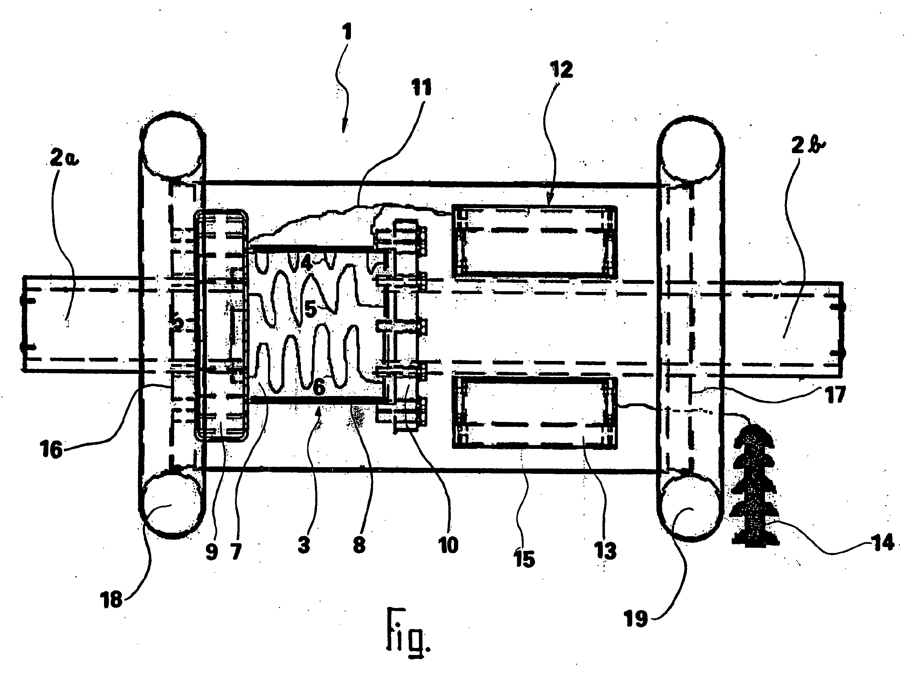

Im Folgenden wird die Erfindung anhand einer Ausführungsform unter Bezugnahme auf die Zeichnung näher erläutert, in deren einziger Figur eine Ausführungsform einer erfindungsgemäßen Messanordnung zur Messung eines in einer Stromschiene fließenden Stroms prinzipiell dargestellt ist.

Eine in der einzigen Figur gezeigte Messanordnung 1 dient der Messung eines in einer Stromschiene 2a, 2b fließenden Stroms. Hierbei ist es unerheblich, ob es sich bei dem die Stromschiene 2a, 2b durchfließenden Strom um einen Gleichstrom oder einen Wechselstrom handelt, wobei die Messung für Wechselspannungen bis in den Kilohertzbereich hinein geeignet ist.

Ein Stromsensor 3, der als ohmscher Stromsensor und insbesondere als niederohmiger Widerstand ausgebildet ist, ist in die Stromschiene 2a, 2b eingebaut, und zwar zwischen dem in der einzigen Figur linken Stromschienenabschnitt 2a und dem in der einzigen Figur rechten Stromschienenabschnitt 2b.

Um den vorstehend erwähnten Messbereich der Messanordnung 1 sowohl für Gleichstrom als auch für Wechselstrom zu realisieren, hat der ohmsche Stromsensor 3 ein aus einer Vielzahl von Leiterdrähten 4, 5, 6 ausgebildetes Widerstandsgewebe, wobei in der einzigen Figur lediglich drei dieser Leiterdrähte 4, 5, 6 dargestellt sind. In der gezeigten Ausführungsform der Messanordnung 1 verlaufen die Leiterdrähte 4, 5, 6 mäandernd an einem zylindrisch ausgestalteten Trägerkörper 7. Die einzelnen Leiterdrähte 4, 5, 6 sind getrennt voneinander am Trägerkörper 7 angebracht, wobei zur Trennung der Leiterdrähte 4, 5, 6 voneinander und zur Fixierung derselben auf der Außenfläche des zylindrischen Trägerkörpers 7 ein isolierender Werkstoff 8 dient, bei dem es sich um ein für derartige Isolier- und Fixierzwecke geeignetes Harz handeln kann.

Zum Einbau bzw. zum Anschluss des Stromsensors 3 in die Stromschiene 2a, 2b dienen Anschlussteile 9, 10, wobei das Anschlussteil 9 den Stromsensor 3 bzw. dessen Leiterdrähte 4, 5, 6 mit dem in der einzigen Figur linken Stromschienenabschnitt 8 und das Anschlussteil 10 entsprechend die Leiterdrähte 4, 5, 6 des Stromsensors 3 mit dem in der einzigen Figur rechten Stromschienenabschnitt 2b verbindet.

Die am ohmschen Stromsensor 3 abfallende Spannung wird mittels eines Spannungsabgriffs 11 abgegriffen und an eine Elektronikeinheit 12 der Messanordnung 1 weitergeleitet. In der Elektronikeinheit 12 wird das entsprechende Messsignal in ein optisches Signal umgewandelt. Zu der Elektronikeinheit 12 gehört ein optischer Sender 13, mittels dem das in der Elektronikeinheit 12 erstellte optische Signal in ein optisches Übertragungssystem 14 eingekoppelt wird. Durch das optische Übertragungssystem 14, das aus geeigneten Lichtwellenleitern aufgebaut ist, wird das optische Signal an eine in der einzigen Figur nicht gezeigte Messwarte weitergeleitet. Dort wird das optische Signal in ein elektrisches Signal zurück verwandelt und als elektrisches delt und als elektrisches Signal einer Messwertverarbeitungseinheit bzw. einem Leitsystem zugeführt.

Die Messanordnung 1 ist innerhalb eines Gehäuses 15 angeordnet, durch dessen in der einzigen Figur linke 16 und rechte Stirnseite 17 der Stromschienenabschnitt 2a bzw. der Stromschienenabschnitt 2b in das Gehäuse 15 geführt sind. An beiden Stirnseiten 16, 17 ist das Gehäuse 15 bzw. die Messanordnung 1 mit einer Abschirmelektrode 18 bzw. 19 versehen.

Die Elektronikeinheit 12 und der optische Sender 13 sind mit dem Stromsensor 3 in diesem Gehäuse angeordnet, wobei die Elektronikeinheit 12 und der optische Sender 13 einerseits galvanisch von der Stromschiene 2a, 2b und dem ohmschen Stromsensor 3 andererseits getrennt sind.

## Patentansprüche

1. Messanordnung zur Messung eines in einer Stromschiene (2a, 2b) fließenden Stroms, mit einem Stromsensor (3), der als ohmscher Stromsensor (3) ausgebildet, in die Stromschiene (2a, 2b) eingebaut und vom die Stromschiene (2a, 2b) durchfließenden Strom durchflossen ist, **dadurch gekennzeichnet, dass** der in die den zu messenden Strom führende Stromschiene (2a, 2b) eingebaute ohmsche Stromsensor (3) als Widerstandsgewebe (4, 5, 6) mit einer Vielzahl voneinander getrennter und isolierter Leiterdrähte (4, 5, 6) ausgebildet ist.

2. Messanordnung nach Anspruch 1, bei der der ohmsche Stromsensor (3) als niederohmiger Widerstand ausgebildet ist.

3. Messanordnung nach Anspruch 1 oder 2, bei dem die Leiterdrähte (4, 5, 6) des ohmschen Stromsensors (3) mäandernd an einem Trägerkörper (7) angebracht sind.

4. Messanordnung nach Anspruch 3, bei der der Trägerkörper (7) zylindrisch ausgebildet ist.

5. Messanordnung nach einem der Ansprüche 1 bis 4, bei der die Leiterdrähte (4, 5, 6) mittels eines isolierenden Werkstoffs (8) voneinander getrennt und am Trägerkörper (7) fixiert sind.

6. Messanordnung nach Anspruch 5, bei der als isolierender Werkstoff (8) ein geeignetes Harz vorgesehen ist.

7. Messanordnung nach einem der Ansprüche 1 bis 6, mit einer Elektronikeinheit (12), der die am ohmschen Stromssensor (3) abfallende und dort mittels eines Spannungsabgriffs (11) abgegriffene Spannung zuführbar ist.

8. Messanordnung nach Anspruch 7, bei der die Elektronikeinheit (12) so ausgestaltet ist, dass mittels ihr das ihr über den Spannungsabgriff (11) zugeführte Messsignal in ein optisches Signal umwandelbar ist, wobei die Elektronikeinheit (12) einen optischen Sender (13) aufweist, mittels dem das optische Signal über ein optisches Übertragungssystem (14) an eine Messwarte weiterleitbar ist.

9. Messanordnung nach Anspruch 8, bei dem das optische Übertragungssystem (14) aus Lichtwellenleitern aufgebaut ist.

10. Messanordnung nach Anspruch 8 oder 9, bei der in der Messwarte das optische Signal in ein elektrisches Signal wandelbar und als solches einer Messwertverarbeitungseinheit bzw. einem Leitsystem zuführbar ist.

11. Messanordnung nach einem der Ansprüche 8 bis 10, bei der die Elektronikeinheit (12) und der optische Sender (13) einerseits galvanisch getrennt von der Stromschiene (2a, 2b) und dem ohmschen Stromsensor (3) andererseits in einem gemeinsamen Gehäuse (15) angeordnet sind.

12. Messanordnung nach Anspruch 11, bei der das Gehäuse (15) an seinen beiden Stirnseiten (16, 17), durch die hindurch die Stromschiene (2a, 2b) eingeführt ist, jeweils eine Abschirmelektrode (18, 19) aufweist.

13. Messanordnung nach einem der Ansprüche 1 bis 12, bei der der ohmsche Stromsensor (3) mittels zweier Anschlussteile (9, 10) in die Stromschiene (2a, 2b) eingebaut ist.

## Claims

1. A measuring arrangement for measuring a current flowing in a contact rail (2a, 2b), with a current sensor (3) which is constructed as an ohmic current sensor (3), integrated into the contact rail (2a, 2b) and flowed through by the current which flows through the contact rail (2a, 2b), **characterised in that** the ohmic current sensor (3) integrated into the contact rail (2a, 2b), which carries the current to be measured, is constructed as a resistance web (4, 5, 6) with a multiplicity of mutually separated and insulated conductor wires (4, 5, 6).

2. The measuring arrangement according to Claim 1, in which the ohmic current sensor (3) is constructed as a low-ohmic resistor.

3. The measuring arrangement according to Claim 1 or 2, in which the conductor wires (4, 5, 6) of the ohmic current sensor (3) are applied in a meandering manner on a support body (7).

4. The measuring arrangement according to Claim 3, in which the support body (7) is constructed cylindrically.

5. The measuring arrangement according to one of Claims 1 to 4, in which the conductor wires (4, 5, 6) are separated from one another by means of an insulating material (8) and fixed on the support body (7).

6. Measuring arrangement according to Claim 5, in which a suitable resin is provided as insulating material (8).

7. The measuring arrangement according to one of Claims 1 to 6, with an electronic unit (12), to which the voltage falling at the ohmic current sensor (3) and tapped there by means of a voltage tap (11) can be supplied.

8. The measuring arrangement according to Claim 7, in which the electronic unit (12) is configured in such a manner that by means of the same, the measuring signal supplied to the same via the voltage tap (11) can be converted into an optical signal, wherein the electronic unit (12) has an optical transmitter (13), by means of which the optical signal can be forwarded via an optical transmission system (14) to a measuring station.

9. Measuring arrangement according to Claim 8, in which the optical transmission system (14) is constructed from optical waveguides.

10. The measuring arrangement according to Claim 8 or 9, in which the optical signal can be converted into an electrical signal in the measuring station and as such can be supplied to a measured-value processing unit or a control system.

11. The measuring arrangement according to one of Claims 8 to 10, in which the electronic unit (12) and the optical transmitter (13) are on the one hand galvanically separated from the contact rail (2a, 2b) and the ohmic current sensor (3) and are arranged in a common housing (15) on the other hand.

12. The measuring arrangement according to Claim 11, in which the housing (15) has one shielding electrode (18, 19) in each case on both end faces (16, 17) thereof, through which the contact rail (2a, 2b) is inserted.

13. The measuring arrangement according to one of Claims 1 to 12, in which the ohmic current sensor (3) is integrated into the contact rail (2a, 2b) by means of two connection parts (9, 10).

## Revendications

1. Dispositif de mesure pour mesurer un courant circulant dans un rail conducteur (2a, 2b), avec un capteur de courant (3), lequel est réalisé en tant que capteur résistif de courant (3), est intégré dans le rail conducteur (2a, 2b) et est parcouru par le courant circulant à travers le rail conducteur (2a, 2b), **caractérisé en ce que** le capteur résistif de courant (3) intégré dans le rail conducteur (2a, 2b) conduisant le courant à mesurer est réalisé en tant que tissu de résistance (4, 5, 6) avec une pluralité de fils conducteurs (4, 5, 6) séparés les uns des autres et isolés.

2. Dispositif de mesure selon la revendication 1, avec lequel le capteur résistif de courant (3) est réalisé en tant que résistance de basse impédance.

3. Dispositif de mesure selon la revendication 1 ou 2, avec lequel les fils conducteurs (4, 5, 6) du capteur résistif de courant (3) sont montés de manière à former des méandres sur un corps de support (7).

4. Dispositif de mesure selon la revendication 3, avec lequel le corps de support (7) est réalisé de manière cylindrique.

5. Dispositif de mesure selon l'une des revendications 1 à 4, avec lequel les fils conducteurs (4, 5, 6) sont séparés les uns des autres à l'aide d'un matériau isolant (8) et sont fixés sur le corps de support (7).

6. Dispositif de mesure selon la revendication 5, avec lequel on prévoit, en guise de matériau isolant (8), une résine adéquate.

7. Dispositif de mesure selon l'une des revendications 1 à 6, avec une unité électronique (12) à laquelle on peut appliquer la tension chutant au capteur résistif de courant (3) et qui y est prise à l'aide d'une prise de tension (11).

8. Dispositif de mesure selon la revendication 7, avec lequel l'unité électronique (12) est réalisée de manière à ce que grâce à elle, le signal de mesure qui lui est fourni via la prise de tension (11) peut être transformé en un signal optique, moyennant quoi l'unité électronique (12) présente un émetteur optique (13) à l'aide duquel il est possible de retransmettre le signal optique via un système de transmission optique (14) à une station de mesure.

9. Dispositif de mesure selon la revendication 8, avec lequel le système de transmission optique (14) est formé par des conducteurs de lumière.

10. Dispositif de mesure selon la revendication 8 ou 9, avec lequel, dans la station de mesure, le signal optique peut être transformé en signal électrique et peut alimenter en tant que tel une unité de traitement de valeur de mesure et/ou un système conducteur.

11. Dispositif de mesure selon l'une des revendications 8 à 10, avec lequel l'unité électronique (12) et l'émetteur optique (13) sont d'une part séparés galvaniquement du rail conducteur (2a, 2b) et du capteur résistif de courant (3), et sont d'autre part disposés dans un boîtier commun (15).

12. Dispositif de mesure selon la revendication 11, avec lequel le boîtier (15) présente, sur ses deux faces frontales (16, 17) à travers lesquelles on fait passer le rail conducteur (2a, 2b), respectivement une électrode de blindage (18, 19).

13. Dispositif de mesure selon l'une des revendications 1 à 12, avec lequel le capteur résistif de courant (3) est intégré dans le rail conducteur (2a, 2b) à l'aide de deux pièces de raccordement (9, 10).
